# EUROPEAN PATENT APPLICATION

(11) **EP 4 782 850 A1**
(43) Date of publication of application: **29.07.2026**
(21) Application number: 25194249.6
(22) Date of filing: 06.08.2025
(51) Int. Cl.: G01R 29/08, G01R 33/032

(54) **QUANTUM SENSOR DEVICE**

(30) Priority: 23.01.2025 US 202519035256
(71) Applicant: Rohde & Schwarz GmbH & Co. KG, 81671 München (DE)
(72) Inventor: Ruster, Thomas, Dr., 81543 Munich (DE)
(74) Representative: Rupp, Christian

(57) **Abstract**

The present disclosure relates to a quantum sensor device (10), comprising a portable probe (11); and a quantum sensor (12) comprising a sensing volume which is configured to interact with an electric, a magnetic and/or an electromagnetic field to be analyzed; wherein the quantum sensor (12) is arranged in the portable probe (11). The quantum sensor device (10) further comprises a light source (17) configured to irradiate the sensing volume with a light beam, wherein the sensing volume is optically excited by the light beam.

## Description

### Technical Field

The present disclosure relates to a quantum sensor device with a portable quantum probe.

### Background Art

Radio frequency (short: RF) probes can be used to characterize the RF radiation emitted by electronic devices and components. For an accurate measurement, many conventional RF probes are equipped with an antenna with a size of lambda/2, i.e., an antenna with a length that is half of the wavelength (λ) of the RF signal it is designed to receive. This means that the size of the RF probes cannot be further reduced without incurring significant losses in measurement accuracy."

Quantum RF sensors, e.g., based on vapor cells, can be much more sensitive than conventional RF probes. However, most quantum sensor systems are large and inconvenient to operate.

### Summary

Accordingly, there is a need to provide a quantum sensor device with a reduced form factor which is suitable to analyze electronic components.

These and other objectives are achieved by the embodiments as defined by the appended independent claims. Further embodiments are set forth in the dependent claims and in the following description and drawings.

An aspect of the present disclosure relates to a quantum sensor device, comprising a portable probe and a quantum sensor comprising a sensing volume which is configured to interact with an electric, a magnetic and/or an electromagnetic (EM) field to be analyzed; wherein the quantum sensor is arranged in the portable probe. The quantum sensor device further comprises a light source configured to irradiate the sensing volume with a light beam, wherein the sensing volume is optically excited by the light beam.

This achieves the advantage that a relatively small and easy to handle probe can be provided which contains a quantum system that allows for a highly precise measurements of physical quantities of electric, magnetic and/or electromagnetic (e.g., RF or MW) fields which are emitted by a device under test.

The portable probe can be a handheld probe. For example, the probe or more specifically a housing of the probe is shaped to be held with a single hand.

In an implementation form, the sensing volume comprises a number of atoms or components behaving as atoms forming a quantum system.

The number of atoms or atom-like components can be in a ground state or an excited quantum state, depending on an excitation. For example, the atoms or components can be optically excited from the ground state to the excited state by the light beam and/or by a control field.

In an implementation form, the sensing volume comprises a quantum gas which is stored in a vapor cell, or the sensing volume by a solid material. If the sensing volume comprises the quantum gas, the vapor cell can be arranged in the portable probe.

The atoms forming the quantum system can be Rydberg atoms, e.g., in a gaseous form. In case the sensing volume comprises a solid material, this material can be a diamond material comprising the number of atoms or atom-like (micro)components in the form of NV defects.

In an implementation form, the portable probe has a pen shaped housing; and the sensing volume is arranged in or at a tip of the pen shaped housing.

In an implementation form, the quantum sensor device further comprises an optical line arranged to guide the light beam from the light source to the sensing volume.

For example, the optical line is an optical fiber. The light source can be arranged outside of the portable probe and connected to the portable probe via the optical line. However, the light source could also be arranged in the portable probe.

The light source can comprise one or more lasers or laser diodes. Accordingly, the light beam can be a laser beam.

In an implementation form, the quantum sensor device further comprises: a controller configured to control and/or adapt the irradiation of the sensing volume with the light beam, and/or to read-out a response of the quantum sensor to the electric, magnetic and/or electromagnetic field to be analyzed.

For instance, the controller is configured to control the light source to generate and/or adapt the light beam with certain characteristics (e.g., intensity).

In an implementation form, the quantum sensor device further comprises at least one field generator configured to generate an electric, a magnetic and/or an electromagnetic control field within the sensing volume. For example, a resonance frequency of the number atoms or atom-like components in the sensing volume is modified by an amplitude of the electric and/or magnetic control field.

In an implementation form, the controller is configured to control the field generator to generate and/or adapt the electric, magnetic and/or electromagnetic control field in order to adapt a parameter of the quantum sensor.

For instance, a resonant frequency of the number atoms (or of the components behaving as atoms) in the sensing volume is modified by changing an amplitude of the control field (e.g., an E-filed or a B-field). This can be used to sense a physical property of the electric, magnetic or electromagnetic field to be analyzed. The physical property could be an amplitude of an EM field (e.g., an RF signal emitted by a device under test).

In an implementation form, the field generator is calibrated to the characteristics of the quantum sensor.

In an implementation form, the controller is arranged in the portable probe or is arranged external to the portable probe. For instance, the controller can be arranged in a base station which is connected to the probe via one or more cables. The light source could also be arranged in the base station.

In an implementation form, the quantum sensor device further comprises a temperature controller configured to adapt the temperature of the sensing volume. This achieves the advantage that the quantum sensor can be operated under controlled conditions, which increases the measuring accuracy.

For example, the temperature controller comprises a heater.

In an implementation form, the quantum sensor device further comprises a positional sensor configured to detect a position and/or orientation of the portable probe and/or of the quantum sensor arranged in the portable probe.

The position sensor and/or the controller can map the detected position and/or orientation to a sensor read-out. In this way, for example, a map of an RF field distribution near a device under test (e.g., an electric circuit) can be created.

In an implementation form, the quantum sensor device further comprises a user interface configured to output information on the electric, magnetic and/or electromagnetic field to be analyzed which is determined by the quantum sensor device based on the interaction of the quantum sensor with the field.

### Brief Description of the Drawings

Exemplary embodiments of the disclosure are now further explained with respect to the drawings by way of example only, and not for limitation. In the drawings:

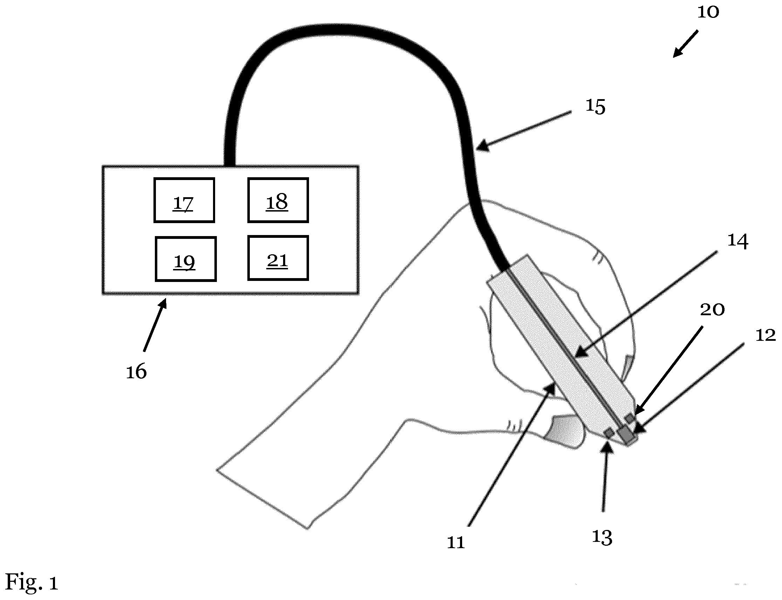

Fig. 1 shows a schematic diagram of a quantum sensor device according to an embodiment.

### Detailed Descriptions of Embodiments

Fig. 1 shows a schematic diagram of a quantum sensor device 10 according to an embodiment. The quantum sensor device 10 comprises a portable probe 11, and a quantum sensor 12 comprising a sensing volume which is configured to interact with an electric, a magnetic and/or an electromagnetic field to be analyzed; wherein the quantum sensor 12 is arranged in the portable probe 11. The quantum sensor device 10 further comprises a light source 17 configured to irradiate the sensing volume with a light beam, wherein the sensing volume is optically excited by the light beam.

The portable probe 11 can have a pen shaped housing. As shown in Fig. 1, the pen shaped housing can be shaped to be held with a single hand.

The quantum sensor 12 or more specifically the sensing volume can be arranged in or at a tip of the pen shaped housing.

Due to the pen shaped housing, the probe 11 can be conveniently handled by a user. For instance, during a typical mode of operation, a user may hold the probe 11 such that its head (with the quantum sensor 12) is close to a device under test, e.g. an electrical circuit emitting a field to be analyzed. In this way, the probe 11 can perform contactless field measurements of, e.g., electric or magnetic fields above the device under test. This measurement can be done in the context of an analysis and/or a debugging of the device under test (e.g., a hardware under development). The quantum sensor 12 can be optimized to limit field distortions, especially because the quantum sensor 12 does not require metallic components.

For instance, the portable probe 11 comprises or is formed by a sensor carrier, wherein the quantum sensor 12 is mounted on the sensor carrier.

The sensing volume of the quantum sensor 12 may comprise a number of atoms or components behaving as atoms forming a quantum system. For instance, the sensing volume being optically excited by the light beam may refer to at least a portion of the atoms or components forming the quantum system being optically excited.

For example, the sensing volume comprises a quantum gas which is stored in a vapor cell. The atoms forming the quantum system can be Rydberg atoms.

Alternatively, the sensing volume could be formed by a solid material. The solid material can be a diamond material, which comprises the number (micro)components in the form of NV defects. The sensing volume could comprise the diamond material in a powdered form. For instance, quantum sensors with NV diamonds are excellent for magnetic field sensing, and can be much more sensitive than conventional Hall probes.

The quantum sensor 12 can comprise a miniature quantum sensor plate or chip which comprises the sensing volume. The quantum sensor plate is, e.g., an NV diamond plate, or a miniaturized atomic vapor cell.

The portable probe 11 may be connected to a base station 16 of the sensor device 10. For instance, the light source 17 is arranged in the base station 16. Alternatively, the light source 17 could also be arranged in the portable probe 11.

The quantum sensor device can comprise an optical line 14 which is arranged to guide one or more light beams from the light source 17 to the sensing volume of the quantum sensor 12. The optical line 14 can comprise fiber(s), wire(s) and/or waveguide(s). In case the light source 17 is arranged in the base station 16 and, thus, external to the portable probe 11, the optical line 14 can at least partially run through a connecting cable 15 which connects the base station 16 with the portable probe 11.

Optionally, the quantum sensor device 10 further comprises at least one field generator 13 configured to generate an electric, a magnetic and/or an electromagnetic control field within the sensing volume.

The field generator 13 can be arranged in the portable probe 12 as shown in Fig. 1. Alternatively, the field generator 13 could also be arranged in the base station 16, such that the control fields are generated in the base station and guided to the quantum sensor via the cable 15, for instance, in case the control field is an electromagnetic field (e.g., an RF signal).

The field generator 13 can comprise a capacitor to generate an electric control field, a magnet to generate a magnetic control field and/or an EM source, such as an RF signal generator, to generate the electromagnetic control field.

The quantum sensor device 10 may further comprise a controller 18 configured to control and/or adapt the irradiation of the sensing volume with the light beam. For instance, the controller 18 is adapted to control the light output of the light source 17. The controller 18 may further be configured to control the field generator 13 in order to generate and/or adapt the electric, magnetic and/or electromagnetic control fields.

The quantum sensor 12 can be adapted by the light beam and, optionally, by the additional control fields (e.g., an RF or magnetic field). For example, the atoms or the atom-like components in the sensing volume are optically excited from a ground state to an excited state by the light beam. Furthermore, a characteristic of the quantum sensor, e.g. a resonant frequency of the excited atoms or components, can be adapted by changing a parameter of the light beam and/or the control fields. Thus, by adapting the operation of the light source 17 and/or the field generator 13, the controller 18 can act as an actuator which changes parameters of the quantum sensor (e.g., its resonant frequency). In this way, an operating mode of the quantum sensor device 10, e.g., whether the quantum sensor 12 responds to magnetic, electric and/or MW fields, can be set.

For example, the controller 18 dynamically controls the light beam and/or the control fields. An example for this control is a laser frequency sweep and/or a magnetic field sweep in order to adjust the resonant frequency of the quantum sensor 12.

Furthermore, the controller 18 may be configured to read-out a response of the quantum sensor to the electric, magnetic and/or electromagnetic field to be analyzed. For example, the controller 18 comprises or is connected to a detector 21 which reads-out the response of the quantum sensor 12, i.e. the response of the atoms or atom-like components in the sensing volume, to the field to be analyzed.

For example, the detector 21 is a separate component to the controller 18, and is configured to detect the response of the quantum sensor 12 and delivers data on said response to the controller 18. The response of the quantum sensor 12 can be an optical or an electrical response. The detector 21 is e.g. arranged in the base station 16.

The quantum sensor 12 can be read out in different ways, depending on the type of sensor (e.g. vapor cell or NV diamonds) and on the field to be analyzed. For example, the field to be analyzed is an EM radiation which interacts with the sensing volume (e.g., Rydberg atoms in a vapor cell). This interaction can be indicative of a power level of the EM radiation. For instance, if the EM radiation is resonant (or near-resonant) to two energy levels in the quantum system formed by the Rydberg atoms, it can change the state of the quantum system. This can be read out by optical means, e.g., by an optical detector 21 that detects an optical change in the sensing volume due to the interaction. In a further example, the field to be analyzed (e.g., a magnetic field) causes an ionization in the sensing volume. This could be read out by detecting a current between two measurement electrodes which are arranged on opposite sides of the sending volume

The controller 18 can be arranged external to the portable probe 11, e.g. in the base station 16 as shown in Fig. 1. Alternatively, the controller 18 can be integrated into the portable probe 11.

The controller 18 can comprise a processor and/or further control electronics.

The quantum sensor device 10 can comprise a position sensor 20 configured to detect a position and/or orientation of the portable probe 11 and/or of the quantum sensor 12 arranged in the portable probe.

For instance, the position sensor 20 is arranged in the head of the probe 11 to localize the current position of the quantum sensor 12 (e.g., a sensor plate) in space. By moving the probe head within a region of interest and performing such a location tracking, a field map, e.g. a magnetic field map above an electrical circuit, can be generated by the controller 18. The field map can map measured values of a field to the location.

For example, the position sensor 20 comprises a gyroscope.

Besides the field generator 13, the quantum sensor device 10 can comprise additional control units. For example, the sensor device 10 comprises a temperature controller configured to adapt the temperature of the sensing volume. The temperature controller could be a heater. By means of the temperature controller, the sensing volume can be kept at a target temperature and, thus, unwanted fluctuation of sensor parameters (e.g., the resonant frequency) can be avoided.

The temperature controller is preferably arranged near the sensing volume, e.g., at or near the tip of the portable probe 11.

The quantum sensor device 10 can further comprise a user interface 19 configured to provide a read-out of the quantum sensor 12. For instance, the user interface 19 outputs an information on the electric, magnetic and/or electromagnetic field to be analyzed, which can be determined by the quantum sensor device or more specifically the controller 18 based on the interaction of the quantum sensor 12 with the field to be analyzed.

According to an example, the field generator and/or the light source is calibrated to characteristics of the quantum sensor at least once prior to a sensing operation. For instance, during calibration, the quantum sensor can be exposed to a known electric, magnetic and/or electromagnetic field, and the response of the sensor to this field is recorded. In this way, a calibration curve or function could be determined and stored by the controller 18.

While various embodiments of the present disclosure have been described above, it should be understood that they have been presented by way of example only, and not limitation. Numerous changes to the disclosed embodiments can be made in accordance with the disclosure herein, without departing from the spirit or scope of the disclosure. Thus, the breadth and scope of the present disclosure should not be limited by any of the above-described embodiments. Rather, the scope of the disclosure should be defined in accordance with the following claims and their equivalents.

Although the disclosed embodiments have been illustrated and described with respect to one or more implementations, equivalent alterations and modifications will occur or be known to others skilled in the art upon the reading and understanding of this specification and the annexed drawings. In addition, while a particular feature of the present disclosure may have been disclosed with respect to only one of several implementations, such feature may be combined with one or more other features of the other implementations as may be desired and advantageous for any given or particular application.

## Claims

1. A quantum sensor device (10), comprising:
a portable probe (11);
a quantum sensor (12) comprising a sensing volume which is configured to interact with an electric, a magnetic and/or an electromagnetic field to be analyzed;
wherein the quantum sensor (12) is arranged in the portable probe (11); and
a light source (17) configured to irradiate the sensing volume with a light beam, wherein the sensing volume is optically excited by the light beam.

2. The quantum sensor device (10) of claim 1,
wherein the sensing volume comprises a number of atoms or components behaving as atoms forming a quantum system.

3. The quantum sensor device (10) of claim 1 or 2,
wherein the sensing volume comprises a quantum gas which is stored in gas cell, or wherein the sensing volume comprises a solid material.

4. The quantum sensor device (10) of any of the preceding claims,
wherein the portable probe (11) has a pen shaped housing; and
wherein the sensing volume is arranged in or at a tip of the pen shaped housing.

5. The quantum sensor device (10) of any of the preceding claims, further comprising:
an optical line arranged to guide the light beam from the light source (17) to the sensing volume.

6. The quantum sensor device (10) of any of the preceding claims, further comprising:
a controller (18) configured to control and/or adapt the irradiation of the sensing volume with the light beam and/or to read-out a response of the quantum sensor (12) to the electric, magnetic and/or electromagnetic field to be analyzed.

7. The quantum sensor device (10) of any of the preceding claims, further comprising:
at least one field generator (13) configured to generate an electric, a magnetic and/or an electromagnetic control field within the sensing volume.

8. The quantum sensor device (10) of claims 6 and 7,
wherein the controller (18) is further configured to control the field generator (13) to generate and/or adapt the electric, magnetic and/or electromagnetic control field in order to adapt a parameter of the quantum sensor (12).

9. The quantum sensor device (10) of claim 7,
wherein the field generator (13) is calibrated to the characteristics of the quantum sensor (12).

10. The quantum sensor device (10) of any of the preceding claims,
wherein the controller (18) is arranged in the portable probe (11) or is arranged external to the portable probe (11).

11. The quantum sensor device (10) of any of the preceding claims, further comprising:
a temperature controller configured to adapt the temperature of the sensing volume.

12. The quantum sensor device (10) of any of the preceding claims, further comprising:
a positional sensor configured to detect a position and/or orientation of the portable probe (11) and/or of the quantum sensor (12) arranged in the portable probe (11).

13. The quantum sensor device (10) of any of the preceding claims, further comprising:
a user interface (19) configured to output information on the electric, magnetic and/or electromagnetic field to be analyzed which is determined by the quantum sensor device (10) based on the interaction of the quantum sensor (12) with the field.
